# EUROPÄISCHE PATENTANMELDUNG

(11) **EP 3 246 941 A1**
(43) Veröffentlichungstag der Anmeldung: **22.11.2017**
(21) Anmeldenummer: 16170185.9
(22) Anmeldetag: 18.05.2016
(51) Int. Cl.: H01L 23/051, H01L 23/04

(54) **ELEKTRONISCHE BAUGRUPPE MIT EINEM ZWISCHEN ZWEI SCHALTUNGSTRÄGERN ANGEORDNETEN BAUELEMENT UND VERFAHREN ZUM FÜGEN EINER SOLCHEN BAUGRUPPE**

(71) Anmelder: Siemens Aktiengesellschaft, 80333 München (DE)
(72) Erfinder: Bigl, Thomas, 91074 Herzogenaurach (DE); Hensler, Alexander, 90766 Fürth (DE); Neugebauer, Stephan, 91058 Erlangen (DE); Pfefferlein, Stefan, 90562 Heroldsberg (DE); Strogies, Jörg, 14163 Berlin (DE); Wilke, Klaus, 12527 Berlin (DE)

(57) **Zusammenfassung**

Die Erfindung betrifft eine elektronische Baugruppe, die einen ersten Schaltungsträger (11) und eine zweiten Schaltungsträger (13) aufweist, die eine Kavität (15) ausbilden. In dieser Kavität (15) sind Bauelemente (16) angeordnet, wobei für diese im ersten Schaltungsträger (11) Kontaktbereiche (21) vorgesehen sind. Diese Kontaktbereiche sind erfindungsgemäß nachgiebig, insbesondere elastisch ausgebildet, damit Toleranzen durch eine Verformung dieser Kontaktbereiche (21) aufgefangen werden können. Hierdurch ist vorteilhaft ein zuverlässiges Fügen der Baugruppe auch bei Mehrfachtoleranzen der Fügepartner möglich.

## Beschreibung

Elektronische Baugruppe mit einem zwischen zwei Schaltungsträgern angeordneten Bauelement und Verfahren zum Fügen einer solchen Baugruppe

Die Erfindung betrifft eine elektronische Baugruppe, die folgende Komponenten aufweist:
einen ersten Schaltungsträger mit einer ersten Montageseite für elektronische Bauelemente,
einen zweiten Schaltungsträger mit einer zweiten Montageseite für elektronische Bauelemente, wobei der zweite Schaltungsträger mit der zweiten Montageseite der ersten Montageseite des ersten Schaltungsträgers zugewandt mit diesem verbunden ist,
mindestens ein elektronisches Bauelement, welches sowohl mit der ersten Montageseite als auch mit der zweiten Montageseite verbunden ist.

Außerdem betrifft die Erfindung ein Verfahren zum Fügen einer solchen elektronischen Baugruppe.

Baugruppen der eingangs angegebenen Art sind beispielsweise aus der DE 10 2014 206 601 A1 bekannt. Bei dem in dieser Veröffentlichung beschriebenen Bauelement handelt es sich um ein Leistungsbauelement, welches Kontaktflächen an seiner Oberseite und seiner Unterseite aufweist. Mit der Unterseite ist das Bauelement mit einem keramischen Substrat elektrisch leitend verbunden. Ein zweiter Schaltungsträger in Form einer Haube ermöglicht die Kontaktierung auf der Oberseite des Bauelements, wobei dieser Schaltungsträger Leitpfade aufweist, die eine Kontaktierung auf dem ersten Schaltungsträger, also auf einer anderen Ebene ermöglichen. Der haubenförmige Schaltungsträger ist daher zur Ausbildung einer Kavität geeignet, in der das Bauelement zwischen den beiden Schaltungsträgern gehalten werden kann, so dass unterschiedliche Verdrahtungsebenen entstehen. Hierbei entsteht wegen des Bedarfs der Kontaktierung auf unterschiedlichen Ebenen und auf unterschiedlichen Bauteilen ein statisch überbestimmtes System, so dass für ein zuverlässiges Kontaktieren ein Toleranzausgleich gewährleistet sein muss.

Für einen Toleranzausgleich in einer ähnlich gestalteten Baugruppe wird gemäß der DE 10 2014 206 608 A1 eine Lösung angegeben. Der haubenförmige Schaltungsträger ist gemäß dieser Veröffentlichung aus mehreren plastisch verformbaren Lagen aufgebaut, wobei zwischen diesen Lagen auch Lagen zur Verdrahtung und Kontaktierung vorgesehen sind. Dieser Schaltungsträger kann nach Montage des Bauelements auf den ersten Schaltungsträger aufgesetzt werden und während des Lötens der Kontaktierungen mit einer Fügekraft beaufschlagt werden. Dabei verformt sich der Schaltungsträger, wobei Toleranzen gleichzeitig ausgeglichen werden. Die für das Löten erforderliche Wärme sorgt gleichzeitig dafür, dass das Material des Schaltungsträgers aushärtet, wobei gleichzeitig eine abgedichtete Kavität für das Bauelement entstehen kann.

Weiterhin ist es aus der US 2011/0127663 A1 bekannt, dass Bauelemente auch in einer durch eine Haube gebildetem Kavität gegen die Außenwelt abgedichtet werden können. Die Haube wird mittels eines Dichtmittels auf dem Substrat für das Bauelement befestigt, so dass die Kavität hermetisch gegen die Umgebung abgedichtet ist. Außerdem kann ein thermisches Verbindungsmaterial zwischen dem Bauelement und der Haube vorgesehen werden, so dass diese Wärme aufnehmen kann, die in dem Bauelement entsteht.

Wie sich zeigt, sind die oben dargestellten Lösungen umso komplexer, je mehr Funktionen in die Schaltungsträger integriert werden sollen. Gleichzeitig wirft eine zuverlässige Kontaktierung aufgrund der statischen Überbestimmtheit der beschriebenen Systeme Probleme auf.

Die Aufgabe der Erfindung liegt daher darin, eine elektronische Baugruppe, bei der das Bauelement zwischen zwei Schaltungsträgern gehalten werden und elektrisch kontaktiert werden soll, dahingehend zu verbessern, dass einerseits eine zuverlässige Kontaktierung des Bauelements ermöglicht wird und andererseits eine kostengünstige Herstellung und Montage der Komponenten möglich ist.

Diese Aufgabe wird mit der eingangs angegebenen elektronischen Baugruppe erfindungsgemäß dadurch gelöst, dass der erste Schaltungsträger in einem zwischen dem ersten Schaltungsträger und dem Bauelement ausgebildeten Kontaktbereich sowohl im Vergleich zum den Kontaktbereich umgebenden ersten Schaltungsträger als auch im Vergleich zum zweiten Schaltungsträger nachgiebig in Richtung senkrecht zur ersten Montageseite ausgeführt ist. Durch die nachgiebige Ausführung kann erfindungsgemäß erreicht werden, dass Maßtoleranzen und Lagetoleranzen der beteiligten Fügepartner, d. h. der beiden Schaltungsträger, dem Bauelement und Depots aus einem Fügehilfsstoff, z. B. einem Lotwerkstoff oder einem Sinterwerkstoff, dadurch ausgeglichen werden können, dass der Kontaktbereich beim Fügen in Fügerichtung und damit senkrecht zur ersten Montageseite und bevorzugt auch zur zweiten Montageseite nachgibt. Dabei kann eine Verbindung der Bauelemente oder des Bauelements mit dem ersten und/oder dem zweiten Schaltungsträger elektrisch und/oder thermisch erfolgen. Wenn im Folgenden von einem Schaltungsträger oder beiden Schaltungsträgern die Rede ist, ist damit immer der erste Schaltungsträger und der zweite Schaltungsträger bzw. einer von diesen Schaltungsträgern gemeint, wenn es nicht darauf ankommt, ob die Aussage für den ersten Schaltungsträger oder den zweiten Schaltungsträger gemacht wird.

Der Ausgleich der Toleranzen durch den nachgiebigen Kontaktbereich, also demjenigen Bereich auf dem ersten Schaltungsträger, auf dem das Bauelement evtl. unter Zuhilfenahme eines Fügehilfsstoffs aufgesetzt ist, ist daher so wichtig, weil die elektronische Baugruppe aufgrund der Vielzahl der auszubildenden Verbindungen statisch überbestimmt ist. Deswegen müssen Toleranzen, die bei den Fügepartnern unterschiedlich groß ausfallen können, durch eine Nachgiebigkeit wenigstens eines Teils der Fügepartner ausgeglichen werden. Diese Nachgiebigkeit ist vorteilhaft am einfachsten bei dem ersten Schaltungsträger zu verwirklichen. Die Baugruppe kann einfach gefügt werden, wobei die Fügestellen vorteilhaft zuverlässig ausgebildet werden.

Gemäß einer vorteilhaften Ausgestaltung der Erfindung ist vorgesehen, dass der Kontaktbereich auf einem Passstück liegt, das mit einer Passung, insbesondere mit Übermaß in einer Aussparung in dem ersten Schaltungsträger eingepasst ist, wobei sich das Passstück senkrecht zur ersten Montageseite in der Aussparung verschieben lässt. Die Nachgiebigkeit des Montagebereichs ist bei dieser Variante vorteilhaft dadurch verwirklicht, dass eine Passung mit Übermaß einerseits zu einer Fixierung des Passstücks in dem ersten Schaltungsträger führt, wobei dieses sich andererseits senkrecht zur ersten Montageseite bewegen lässt, um Toleranzen auszugleichen. Durch eine Spielpassung oder eine Übergangspassung wird alternativ eine sehr leichte Verschiebbarkeit des Passstücks sichergestellt. Diese Konfiguration ist vorteilhaft einfach im Aufbau, wobei die elektronische Baugruppe nach dem Fügen durch ein Verrutschen des Passstücks in der Aussparung weitgehend kräftefrei vorliegt, so dass die elektrischen Verbindungen vorteilhaft unbelastet sind.

Gemäß einer anderen Ausgestaltung der Erfindung ist vorgesehen, dass der Kontaktbereich sowohl im Vergleich zum den Kontaktbereich umgebenden ersten Schaltungsträger als auch im Vergleich zum zweiten Schaltungsträger elastischer in Richtung senkrecht zur ersten Montageseite ausgeführt ist. Elastischer bedeutet mit anderen Worten, dass der Kontaktbereich zumindest in Teilbereichen, insbesondere in dessen Randbereich, mit einem geringeren Elastizitätsmodul ausgestattet ist, als der restliche erste Schaltungsträger und der zweite Schaltungsträger, wodurch die Nachgiebigkeit des Kontaktbereichs durch eine Materialeigenschaft sozusagen intrinsisch erzeugt wird. Dies erzeugt vorteilhaft einen reversiblen Toleranzausgleich, der auch beispielsweise nach einem Reparaturlöten zum Auswechseln des Bauelements erneut zum Einsatz kommen kann.

Gemäß einer Ausgestaltung des elastischen Kontaktbereichs kann vorgesehen werden, dass der Kontaktbereich aus einer Auflage besteht, deren Material eine größere Elastizität aufweist, als das Material des restlichen ersten Schaltungsträgers. Beispielsweise kann die elastische Auflage aus Polysiloxan bestehen. Diese lässt sich vorteilhaft einfach als Folie zumindest in den Kontaktbereichen des ersten Schaltungsträgers aufbringen und bildet dann das Substrat für das Bauelement, auf dem dieses auch kontaktiert werden kann. Vorteilhaft lässt sich der Schaltungsträger einfach herstellen, da das Aufbringen der elastischen Auflage lediglich einen zusätzlichen Montageschritt erfordert.

Alternativ kann in dem Kontaktbereich das Material des ersten Schaltungsträgers auch im Vergleich zum den Kontaktbereich umgebenden Schaltungsträger abgedünnt werden. Damit ist gemeint, dass die Materialdicke des Schaltungsträgers in diesem Bereich eine geringere Dicke aufweist, als in den Kontaktbereichen umgebenden Zonen des Schaltungsträgers. Auf diese Weise wird in dem Kontaktbereich eine größere Elastizität erzeugt, was vorteilhaft durch einen einfach durchzuführenden Fertigungsschritt beispielsweise durch Fräsen oder Ätzen erreicht werden kann.

Der abgedünnte Bereich kann vorteilhaft fortgebildet werden, indem das Material des abgedünnten Bereichs in den ersten Schaltungsträger einlaminiert ist und im Kontaktbereich freigelegt ist. Als Halbzeug für die genannte Struktur kommen beispielsweise laminierte Leiterplatten in Frage, wobei eine dieser laminierten Schichten durch Freilegen als abgedünnter Bereich genutzt wird. Hierbei kann vorteilhaft ein kostengünstig zu beschaffendes, weil technisch weit verbreitetes Halbzeug zur Herstellung des ersten Schaltungsträgers verwendet werden. Das Material kann vorteilhaft Polyimid sein. Es kann eine an sich bekannte Herstellungstechnologie zur Herstellung sogenannter Flex-Starr-Leiterplatten verwendet werden, welche Teilbereiche aufweisen, die flexibel sind und Teilbereiche aufweisen, die im Vergleich dazu starr sind. Erfindungsgemäß werden die flexiblen Teilbereiche als Kontaktbereich für das Bauelement verwendet.

Gemäß einer weiteren Ausgestaltung der Erfindung kann vorgesehen werden, dass der Rand des Kontaktbereichs durch Ausnehmungen geschwächt ist. Die Schwächung des Rands des Kontaktbereichs führt dazu, dass der Kontaktbereich als Ganzes nachgibt, indem der durch Ausnehmungen mechanisch geschwächte Rand elastisch verformt wird, wenn sich der Kontaktbereich in Montagerichtung senkrecht zur ersten Montageseite verschiebt. Ausnehmungen können vorteilhaft beispielsweise durch Fräsen oder Ätzen hergestellt werden, weswegen vorteilhaft einfache und zuverlässige Fertigungsverfahren zur Verfügung stehen.

Gemäß einer speziellen Ausgestaltung der Erfindung kann vorgesehen werden, dass die Ausnehmungen aus den ersten Schaltungsträger durchbrechenden Schlitzen bestehen, wobei zwischen den Schlitzen Stege vorgesehen sind, die den Kontaktbereich mit dem restlichen ersten Schaltungsträger verbinden. Auf diese Weise bilden die Stege Biegebalken aus, die als elastischer Bereich genutzt werden können. Diese sind an ihren Enden jeweils mit dem Kontaktbereich und mit dem restlichen ersten Schaltungsträger verbunden. Da die Schlitze den Schaltungsträger durchbrechen, also mit anderen Worten Durchgangsöffnungen in dem Schaltungsträger erzeugen, ist eine Kraftanleitung jeweils nur an den Enden der Biegebalken möglich.

Vorteilhaft können die Stege Verzweigungen und/oder einen Verlauf mit mindestens einem Richtungswechsel in der Ebene der ersten Montageseite aufweisen. Hierdurch kann die Biegesteifigkeit der durch die Stege ausgebildeten Biegebalken vorteilhaft beeinflusst werden und es ist möglich, die Stege an die Geometrie des Kontaktbereichs anzupassen.

Eine andere spezielle Ausgestaltung der Erfindung sieht vor, dass die Ausnehmungen aus Nuten bestehen. Diese Nuten durchbrechen den Schaltungsträger nicht vollständig, sondern sind nur in die erste Montageseite und/oder in eine der ersten Montageseite abgewandte Gegenseite des ersten Schaltungsträgers eingebracht. Sie schwächen damit den Querschnitt des Schaltungsträgers und erzeugen auf diese Weise einen elastischen Bereich, der insbesondere am Rande des Kontaktbereichs angeordnet werden kann. Besonders vorteilhaft ist es, wenn mehrere parallel verlaufende Nuten vorgesehen sind, wobei diese abwechselnd in die erste Montageseite und in die gegenüber liegende Gegenseite eingebracht sind. Hierdurch entsteht eine besonders elastische Struktur ähnlich der eines Faltenbalgs. Insbesondere bei faserverstärkten Leiterplatten, bei denen die Durchbrechung der Verstärkungsfasern durch die Nuten erreicht wird, erhöht sich die Elastizität im Vergleich zum restlichen ersten Schaltungsträger beträchtlich.

Eine weitere Ausgestaltung der Erfindung sieht vor, dass der erste Schaltungsträger in der ersten Montageseite und/oder der zweite Schaltungsträger in der zweiten Montageseite eine Vertiefung aufweist, in der sich das Bauelement befindet. Hierdurch kann das Bauelement vorteilhaft in eine nach außen abgeschlossene Kavität eingebracht werden, die im Bereich der Vertiefung durch den ersten Schaltungsträger und den zweiten Schaltungsträger ausgebildet wird. Diese Kavität kann zusätzlich durch ein elektrisches Isoliermaterial ausgefüllt werden.

Weiterhin kann vorteilhaft vorgesehen werden, dass das Bauelement mit der ersten Montageseite und/oder mit der zweiten Montageseite stoffschlüssig verbunden ist. Hierbei können beispielsweise Lötverbindungen oder Sinterverbindungen oder auch Klebeverbindungen zum Einsatz kommen. Die Verbindungen können zur Übertragung eines elektrischen Stroms oder auch zur Übertragung von Wärme genutzt werden.

Weiter kann vorteilhaft vorgesehen werden, dass das Bauelement mit der ersten Montageseite oder mit der zweiten Montageseite kraftschlüssig verbunden ist. Hierbei wird die Nachgiebigkeit, insbesondere die Elastizität in den Kontaktbereich ausgenutzt, um eine Kraft auf die kraftschlüssige Verbindung auszuüben. Eine solche Verbindung ist dazu geeignet, einen elektrischen Strom und/oder thermische Energie zu übertragen. Vorteilhaft vereinfacht sich hierdurch der Montageprozess für die elektronische Baugruppe, da an der kraftschlüssigen Verbindung ein Fügehilfsstoff eingespart werden kann.

Außerdem wird die oben angegebene Aufgabe erfindungsgemäß auch durch ein Verfahren zum Fügen einer elektronischen Baugruppe gelöst. Dieses ist dadurch gekennzeichnet, dass der erste Schaltungsträger oder der zweite Schaltungsträger mit dem Bauelement bestückt wird. Danach wird der erste Schaltungsträger mit dem zweiten Schaltungsträger gefügt. Dabei werden Verbindungen zwischen dem Bauelement und dem ersten Schaltungsträger und/oder dem zweiten Schaltungsträger ausgebildet. Hierbei entsteht eine elektronische Baugruppe, wie diese bereits vorstehend beschrieben wurde, wobei sich die angegebenen Vorteile ergeben.

Gemäß einer Ausbildung des Verfahrens kann vorgesehen werden, dass zumindest ein Teil der Verbindungen zwischen dem ersten Schaltungsträger, dem zweiten Schaltungsträger und dem Bauelement durch Sintern und/oder durch Löten ausgebildet werden. Hierdurch lassen sich vorteilhaft sehr zuverlässige Verbindungen schaffen, mit denen elektrische Ströme und/oder thermische Energie übertragen werden können.

Weiterhin kann vorteilhaft vorgesehen werden, dass bei dem Verbinden des ersten Schaltungsträgers mit dem zweiten Schaltungsträger eine Fügekraft F auf den nachgiebigen Kontaktbereich aufgebracht wird. Mittels der Fügekraft kann der Kontaktbereich im Rahmen seiner Nachgiebigkeit in Fügerichtung senkrecht zur ersten Montageseite bewegt werden, um z. B. Spalte aufgrund von Maßtoleranzen der Fügepartner zu überwinden. Auch kann auf diesem Wege die Fügekraft auf sich ausbildende elektrische Verbindungen vergrößert werden, was beispielsweise bei der Ausbildung von Sinterverbindung von Vorteil ist.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen:
- Figur 1: ein Ausführungsbeispiel der erfindungsgemäßen elektronischen Baugruppe im schematischen Schnitt,
- Figur 2 bis 6: weitere Ausführungsbeispiele der erfindungsgemäßen Baugruppe, wobei jeweils nur der Kontaktbereich im Querschnitt bzw. als Aufsicht dargestellt ist und wobei diese Kontaktbereiche in einem Aufbau der Baugruppe gemäß Figur 1 vorgesehen werden können und
- Figur 7 und 8: Ausführungsbeispiele des erfindungsgemäßen Verfahrens jeweils in einem Fertigungszustand und im schematischen Querschnitt.

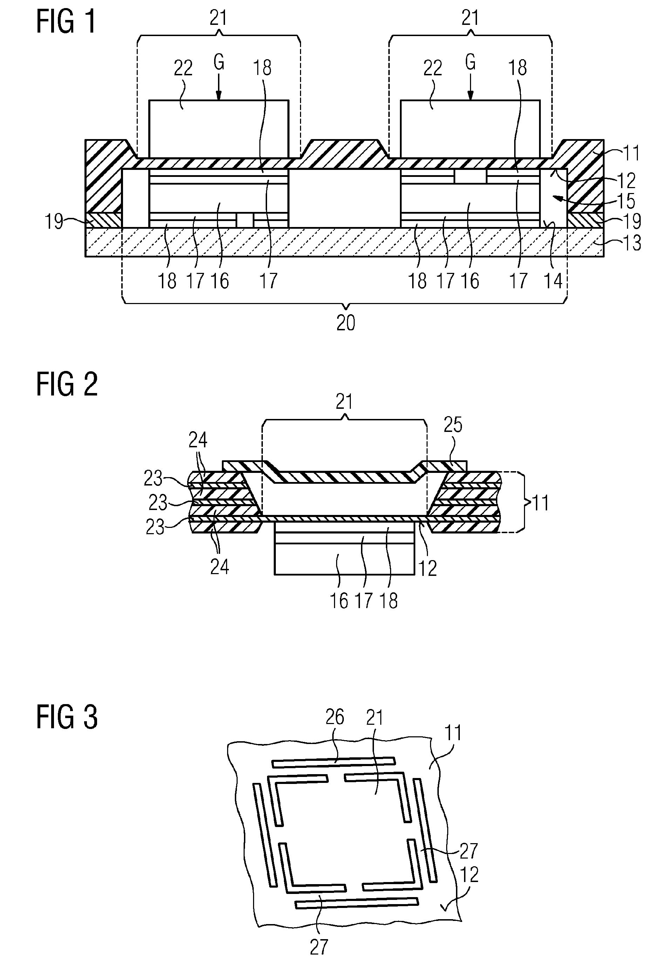

Gemäß Figur 1 ist ein erster Schaltungsträger 11 mit einer ersten Montageseite 12 aus einem Leiterplattenmaterial, beispielsweise epoxidbasierte Systeme wie FR4, und ein zweiter Schaltungsträger 13 mit einer zweiten Montageseite 14 aus einer Keramik, beispielsweise Al₂O₃, Si₃N₄ oder AlN dargestellt. Diese beiden Schaltungsträger 11, 13 bilden eine Kavität 15, in die zwei Bauelemente 16 eingesetzt ist. Die Bauelemente 16 sind über Lötverbindungen 17 jeweils mit der ersten Montageseite 12 und der zweiten Montageseite 14 verbunden. Hierfür stellen die beiden Montageseiten 12, 14 Kontaktpads 18 zur elektrischen Kontaktierung zur Verfügung. Außerdem ist der erste Schaltungsträger 11 über eine Klebeverbindung 19 mit dem zweiten Schaltungsträger 13 elektrisch leitfähig verbunden, wodurch die Kavität 15 nach außen abgedichtet wird.

Die Kavität 15 wird durch eine Vertiefung 20 in dem ersten Schaltungsträger 11 gebildet. Innerhalb dieser Vertiefung sind die Bauelemente 16 untergebracht. Für die Bauelemente 16 sind außerdem Kontaktbereiche 21 vorgesehen, die auf der Montageseite 12 die Kontaktpads 18 tragen. Die Kontaktbereiche 21 sind außerdem durch eine größere Elastizität nachgiebiger ausgestaltet als der Rest des Schaltungsträgers 11, was gemäß Figur 1 durch eine Abdünnung des Materials der Leiterplatte erreicht wird. Hieraus ergeben sich auf der der Montageseite gegenüberliegenden Seite des Schaltungsträgers 11 Vertiefungen, die den Kontaktbereich 21 definieren. In Figur 1 ist dargestellt, dass bei einer Montage beispielsweise Massestücke 22 auf die Kontaktbereiche 21 gelegt werden können, die eine Gewichtskraft G zur Unterstützung eines Zusammenfügens auf den ersten Schaltungsträger 11 ausüben.

In Figur 2 ist zu erkennen, dass der erste Schaltungsträger 11 ein Laminat aus mehreren Lagen 23 ausgebildet ist, die in das Material 24 des Schaltungsträgers einlaminiert sind. Eine der Lagen 23 bildet den abgedünnten Kontaktbereich 21 aus, auf dem das Kontaktpad 18 mit dem Bauelement 16 angeordnet ist. Zusätzlich kann die Abdünnung mit einer Abdeckung 25 versehen werden, um diesen Bereich nach außen zu schützen.

Gemäß Figur 3 ist der Kontaktbereich 21 durch Schlitze 26 in der Montageseite 12 von dem restlichen Schaltungsträger 11 abgetrennt. Zwischen den Schlitzen sind Stege 27 ausgebildet, welche als Biegebalken wirken, so dass hierdurch ein sehr elastischer Bereich entsteht. Die Stege verbinden außerdem den Montagebereich 21 mit dem restlichen Schaltungsträger 11. Der Montagebereich 21 steht für die Montage eines nicht dargestellten Bauelements zur Verfügung. Die Schlitze 26 sind als Durchgangsöffnungen in dem Schaltungsträger 11 ausgeführt, so dass in nicht dargestellter Weise eine Abdeckung 25 analog zur Figur 2 vorgesehen werden kann, wenn die durch die beiden Schaltungsträger 11, 13 gebildete Kavität nach außen abgedichtet sein soll.

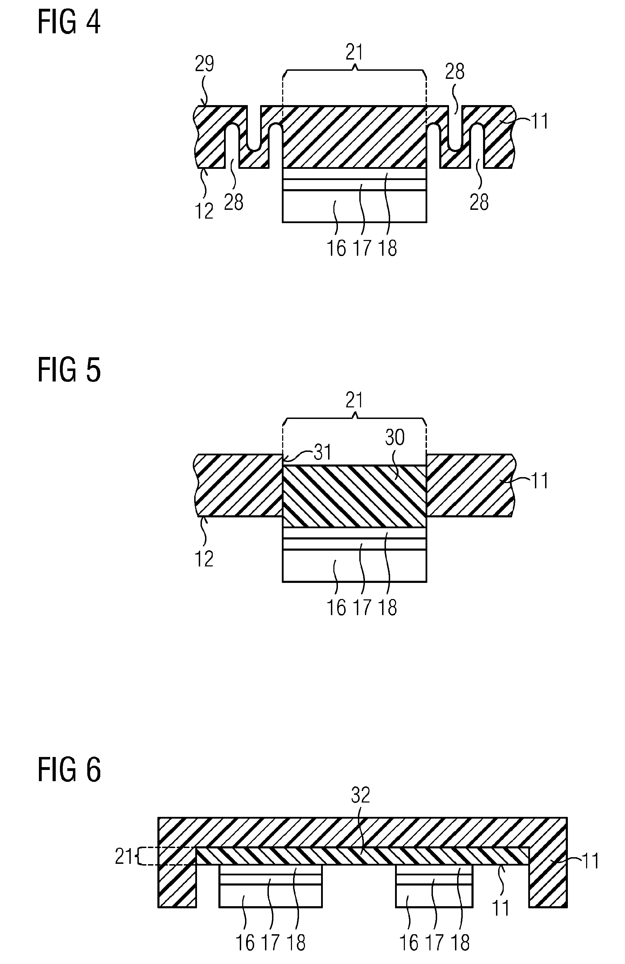

Auch kann eine Struktur gemäß Figur 3 in einen abgedünnten Montagebereich 21 gemäß Figur 1 oder 2 eingebracht werden, um eine zusätzliche Erhöhung der Elastizität zu erreichen. Dies gilt auch für die Struktur gemäß Figur 4, die im Folgenden erläutert werden soll.

In Figur 4 ist zu erkennen, dass der Kontaktbereich 21 am Rand von Nuten 28 gesäumt ist, welche wechselseitig in der ersten Montageseite 12 des Schaltungsträgers 11 und in der dieser Montageseite 12 gegebenüberliegenden Gegenseite 29 vorgesehen sind. Hierdurch entsteht eine Struktur, die mit einem Faltenbalg oder der Randstruktur einer Lautsprechermembran vergleichbar ist und eine extrem geringe Biegesteifigkeit aufweist. Deswegen kann der Kontaktbereich 21 senkrecht zur Fügerichtung leicht bewegt werden.

In Figur 5 ist als Kontaktbereich 21 ein Passstück 30 in eine Aussparung 31 eingebracht, wobei die Nachgiebigkeit des Kontaktbereichs 21 in diesem Ausführungsbeispiel dadurch gewährleistet ist, dass das Passstück 30 in der Aussparung 31 senkrecht zur Ausrichtung der ersten Montageseite 12 beweglich ist. Dabei muss der Widerstand überwunden werden, der sich in der durch ein Übermaß des Passstückes ergebenden Press- oder Übergangspassung reibungsbedingt ergibt.

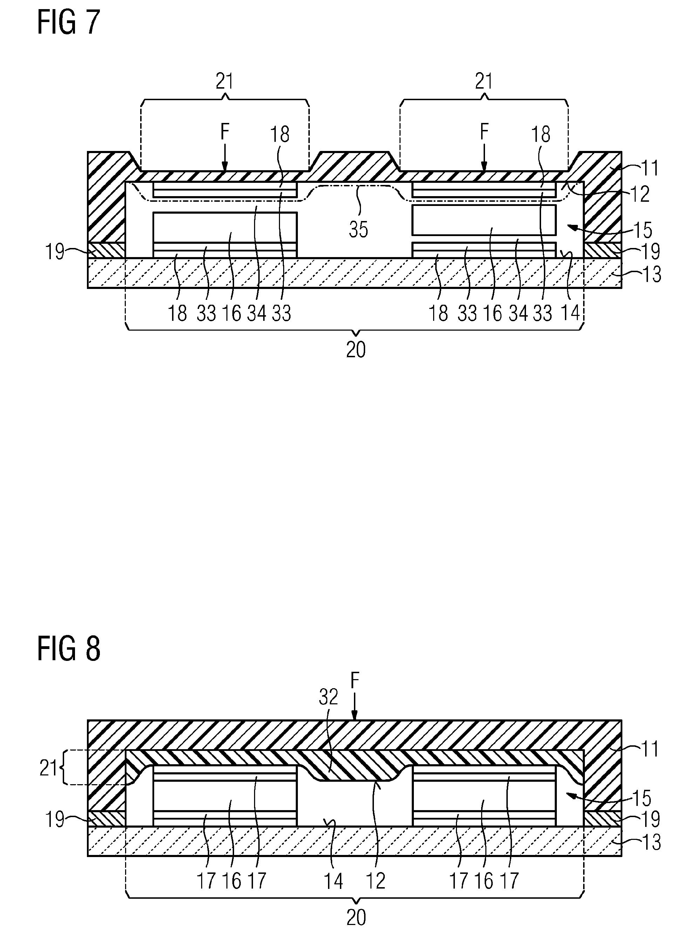

Zuletzt ist in Figur 6 der Kontaktbereich 21 durch eine elastische Auflage 32 aus einer Polysiloxanfolie gebildet, die in der Vertiefung auf den Schaltungsträger 11 aufgelegt und auf ihm befestigt ist (beispielsweise durch Kleben - nicht näher dargestellt) und die erste Montageseite 11 bildet. Die Auflage ist elastischer als der Rest des Schaltungsträgers 11, der beispielsweise durch ein Leiterplattenmaterial gebildet ist. In Figur 7 ist der Montageprozess für die elektronische Baugruppe dargestellt. Es wird deutlich, dass entweder aufgrund des intendierten Fertigungsprozesses gewollt oder aufgrund von Maßtoleranzen der Fügepartner - insbesondere der beiden Schaltungsträger 11, 13, der Bauelemente 16 und von Sinterformteilen 33 - in vormontiertem Zustand der Baugruppe ein Fügespalt 34 verbleibt: Je nachdem, auf welchem der Schaltungsträger 11, 13 das Bauelement 16 vormontiert ist, entsteht der Fügespalt gegenüberliegend zum zugehörigen Sinterformteil 33 (es sind jedoch auch andere Konfigurationen denkbar).

Um diesen Fügespalt zu überbrücken, kann nun eine Fügekraft F während des Sinterns auf den ersten Schaltungsträger 11 wirken, so dass die elastischen Kontaktbereiche 21 sich entsprechend der strichpunktiert dargestellten Biegelinie 35 verformen, wodurch die Fügespalte 34 geschlossen werden. Gleichzeitig wird durch die Fügekraft F ein genügender Druck zur Ausbildung der Sinterverbindungen mittels der Sinterformteile 33 aufgebaut (die entsprechende Fügetemperatur muss selbstverständlich auch eingehalten werden).

In Figur 8 ist zu erkennen, wie sich die elastisch ausgeführte Montageseite 12 bei einem Übermaß der Bauelemente 16 (oder auch von Sinterformteilen, die statt der dargestellten Lötverbindungen angeordnet werden können, vergleiche Figur 7) verformt, wenn eine Fügekraft F auf den Bauteilverbund ausgeübt wird. Bei einem anschließenden Lötvorgang wird über die elastische Verformung der Auflage 32 die Fügekraft F auf die sich ausbildenden Lötverbindungen zumindest zum Teil übertragen, so dass diese sich zuverlässig ausbilden können.

## Patentansprüche

1. Elektronische Baugruppe, aufweisend
• einen ersten Schaltungsträger (11) mit einer ersten Montageseite (12) für elektronische Bauelemente,
• einen zweiten Schaltungsträger (13) mit einer zweiten Montageseite (14) für elektronische Bauelemente, wobei der zweite Schaltungsträger (13) mit der zweiten Montageseite (14) der ersten Montageseite (12) des ersten Schaltungsträgers (11) zugewandt und mit diesem verbunden ist,
• mindestens ein elektronisches Bauelement (16), welches sowohl mit der ersten Montageseite (12) als auch mit der zweiten Montageseite (14) verbunden ist,
**dadurch gekennzeichnet,**
**dass** der erste Schaltungsträger (13) in einem zwischen dem ersten Schaltungsträger (13) und dem Bauelement (16) ausgebildeten Kontaktbereich (21)
• im Vergleich zum den Kontaktbereich (21) umgebenden ersten Schaltungsträger (13) und
• im Vergleich zum zweiten Schaltungsträger (13) nachgiebig in Richtung senkrecht zur ersten Montageseite (12) ausgeführt ist.

2. Baugruppe nach Anspruch 1,
**dadurch gekennzeichnet,**
**dass** der Kontaktbereich (21) auf einem Passstück (30) liegt, das mit einer Passung in eine Aussparung (31) in dem ersten Schaltungsträger (11) eingepasst ist, wobei sich das Passstück (30) senkrecht zur ersten Montageseite (12) in der Aussparung (31) verschieben lässt.

3. Baugruppe nach Anspruch 1 oder 2,
**dadurch gekennzeichnet,**
**dass** der Kontaktbereich (21)
• im Vergleich zum den Kontaktbereich (21) umgebenden ersten Schaltungsträger (13) und
• im Vergleich zum zweiten Schaltungsträger (13) elastischer in Richtung senkrecht zur ersten Montageseite (12) ausgeführt ist.

4. Baugruppe nach Anspruch 3,
**dadurch gekennzeichnet,**
**dass** der Kontaktbereich (21) aus einer Auflage (32) besteht, deren Material eine größere Elastizität aufweist, als das Material des restlichen ersten Schaltungsträgers (11).

5. Baugruppe nach Anspruch 4,
**dadurch gekennzeichnet,**
**dass** die elastische Auflage (32) aus Polysiloxan besteht.

6. Baugruppe nach einem der Ansprüche 3 bis 5,
**dadurch gekennzeichnet,**
**dass** in dem Kontaktbereich (21) das Material des ersten Schaltungsträgers (11) im Vergleich zum den Kontaktbereich umgebenden Schaltungsträger abgedünnt ist.

7. Baugruppe nach Anspruch 6,
**dadurch gekennzeichnet,**
**dass** das Material des abgedünnten Bereiches in den ersten Schaltungsträger (11) einlaminiert ist und im Kontaktbereich (21) freigelegt ist.

8. Baugruppe nach Anspruch 7,
**dadurch gekennzeichnet,**
**dass** das Material des abgedünnten Bereiches Polyimid ist.

9. Baugruppe nach einem der Ansprüche 3 bis 8,
**dadurch gekennzeichnet,**
**dass** der Rand des Kontaktbereiches (21) durch Ausnehmungen geschwächt ist.

10. Baugruppe nach Anspruch 9,
**dadurch gekennzeichnet,**
**dass** die Ausnehmungen aus den ersten Schaltungsträger (11) durchbrechenden Schlitzen (26) bestehen, wobei zwischen den Schlitzen (26) Stege (27) vorgesehen sind, die den Kontaktbereich (21) mit dem restlichen ersten Schaltungsträger (11) verbinden.

11. Baugruppe nach Anspruch 10,
**dadurch gekennzeichnet,**
**dass** die Stege (27) Verzweigungen und/oder einen Verlauf mit mindestens einem Richtungswechsel in der Ebene des ersten Montageseite (12) aufweisen.

12. Baugruppe nach Anspruch 9,
**dadurch gekennzeichnet,**
**dass** die Ausnehmungen aus Nuten (28) bestehen.

13. Baugruppe nach Anspruch 12,
**dadurch gekennzeichnet,**
**dass** mehrere parallel verlaufende Nuten (28) vorgesehen sind, wobei diese abwechselnd in die erste Montageseite (12) und in eine der ersten Montagesseite (12) abgewandte Gegenseite (29) des ersten Schaltungsträgers (11) eingebracht sind.

14. Baugruppe nach einem der voranstehenden Ansprüche,
**dadurch gekennzeichnet,**
**dass** der erste Schaltungsträger (11) in der ersten Montageseite (12) und/oder der zweite Schaltungsträger (13) in der zweiten Montageseite (14) eine Vertiefung (20) aufweist, in der sich das Bauelement (16) befindet.

15. Baugruppe nach Anspruch 14,
**dadurch gekennzeichnet,**
**dass** der erste Schaltungsträger (11) und der zweite Schaltungsträger (13) eine nach außen abgeschlossene Kavität (15) ausbilden.

16. Baugruppe nach einem der voranstehenden Ansprüche,
**dadurch gekennzeichnet,**
**dass** das Bauelement (16) mit der ersten Montageseite (12) und/oder mit der zweiten Montageseite (14) stoffschlüssig verbunden ist.

17. Baugruppe nach Anspruch 16,
**dadurch gekennzeichnet,**
**dass** das Bauelement (16) mit der ersten Montageseite (12) oder mit der zweiten Montageseite (14) kraftschlüssig verbunden ist.

18. Verfahren zum Fügen einer elektronischen Baugruppe nach einem der vorangehenden Ansprüche,
**dadurch gekennzeichnet,**
**dass**
• der erste Schaltungsträger (11) oder der zweite Schaltungsträger (13) mit dem Bauelement (16) bestückt wird,
• danach der erste Schaltungsträger (11) mit dem zweiten Schaltungsträger (13) gefügt wird und
• die Verbindungen zwischen dem Bauelement und dem ersten Schaltungsträger (11) und/oder dem zweiten Schaltungsträger (13) ausgebildet werden.

19. Verfahren nach Anspruch 18,
**dadurch gekennzeichnet,**
**dass** zumindest ein Teil der Verbindungen zwischen dem ersten Schaltungsträger (11), dem zweiten Schaltungsträger (13) und dem Bauelement (16) durch Sintern und/oder durch Löten und/oder durch einen elektrisch leitfähigen Leitkleber ausgebildet werden.

20. Verfahren nach einem der Ansprüche 18 oder 19,
**dadurch gekennzeichnet,**
**dass** bei dem Verbinden des ersten Schaltungsträgers (11) mit dem zweiten Schaltungsträger (13) eine Fügekraft F auf den nachgiebigen Kontaktbereich (21) aufgebracht wird.
